Europäisches Patentamt

European Patent Office

Office européen des brevets

(19)

(11) Numéro de publication : **0 418 117 B1**

(12) **FASCICULE DE BREVET EUROPEEN**

(45) Date de publication du fascicule du brevet :
**06.04.94 Bulletin 94/14**

(51) Int. Cl.$^5$ : **G01N 22/00,** G01R 27/26

(21) Numéro de dépôt : **90402421.3**

(22) Date de dépôt : **03.09.90**

(54) **Dispositif de caractérisation diélectrique d'échantillons de matériau de surface plane ou non plane et application au contrôle non destructif de l'homogénéité diélectrique desdits échantillons.**

(30) Priorité : **05.09.89 FR 8911582**

(43) Date de publication de la demande :
**20.03.91 Bulletin 91/12**

(45) Mention de la délivrance du brevet :
**06.04.94 Bulletin 94/14**

(84) Etats contractants désignés :
**DE DK GB IT NL**

(56) Documents cités :
**PROCEEDINGS OF THE I.E.E.E. - INSTRUMEN-
TATION AND MEASUREMENT TECHNOLOGY
CONFERENCE, 27-29 April 1987 NEW-YORK,
USA. pages 154 - 159; H.MOSCHUERING ET
AL.: "The measurement of inhomogenities
and of the permittivity distribution in MIC-
substrates"
PHYSICS IN MEDECINE AND BIOLOGY. vol.
33, no. 5, May 1988, LONDON GB pages 607 -
612; J.P.GRANT ET AL.: "In vivo dielectric
properties of human skin from 50 MHz to 2.0
GHz"**

(56) Documents cités :
**JOURNAL OF PHYSICS E. SCIENTIFIC INS-
TRUMENTS. vol. 17, no. 1, January 1984, BRIS-
TOL GB pages 30 - 34; M.STEEL ET AL.: "A
precision method for measuring the complex
permittivity of solid tissue in the frequency
domain between 2 and 18 GHz"
INSTRUMENTS AND EXPERIMENTAL TECH-
NIQUES. vol. 30, no. 2, March 1987, NEW YORK
US pages 491 - 492; A.V.GOLIK ET AL.:
"Low-temperature radio frequency matching
device "**

(73) Titulaire : **AEROSPATIALE Société Nationale
Industrielle
37, Boulevard de Montmorency
F-75781 Paris Cédex 16 (FR)**

(72) Inventeur : **Lahitte, Pierre
3 Lotissement "Les Orchidées"
F-33160 Salaunes (FR)**
Inventeur : **Villers, Serge, Avenue du Président
R. Schumann
Résidence Bellini "Appt. 511"
F-33110 Le Bouscat (FR)**

(74) Mandataire : **Mongrédien, André et al
c/o SOCIETE DE PROTECTION DES
INVENTIONS 25, rue de Ponthieu
F-75008 Paris (FR)**

## Description

La présente invention concerne les dispositifs de caractérisation diélectrique d'échantillons en matériau composite de forme plane et/ou non plane. Elle est applicable au contrôle non destructif de l'homogénéité superficielle de ces échantillons.

Elle concerne plus particulièrement les dispositifs permettant de déterminer la permittivité relative $\varepsilon'$ et/ou les pertes $\varepsilon''$ dans le matériau, dans le domaine des fréquences radio et hyperfréquences, plus particulièrement dans la gamme de 100 MHz à 4 GHz.

Les techniques classiques de caractérisation diélectrique des matériaux utilisent des lignes coaxiales, des guides circulaires, rectangulaires, des cavités. Dans la plupart des cas, ces méthodes ont l'inconvénient d'être destructives et il est nécessaire d'usiner un échantillon à la forme du guide de mesure afin de placer cet échantillon à l'intérieur du guide lors des mesures.

On peut se reporter à cet effet à la demande de brevet français publiée sous le N° 2 619 223, intitulée "Procédé et dispositif pour l'estimation des caractéristiques électromagnétiques d'un matériau diélectrique ou magnétique".

Il existe cependant des méthodes de mesure non destructives faisant appel à des cavités ou à des lignes coaxiales ouvertes. Quelques unes de ces méthodes sont rappelées dans ce qui suit afin de bien montrer les limites des méthodes existantes et de montrer les problèmes techniques à résoudre.

Lorsque l'on utilise une cavité fermée pour effectuer de telles mesures, on est limité par le domaine des fréquences.

En effet, les cavités fermées travaillant dans le domaine des hyperfréquences ne sont applicables en conséquence qu'à des échantillons de faibles dimensions, habituellement inférieures à 5 x 5 mm². On pourra se reporter à l'article de X. LE CLEAC'H paru dans la revue Phys. Appl. 17 (1982), pp 481-490.

Lorsque l'on utilise une cavité constituée par une boucle de ligne "microruban" ou "microstrip", on peut déterminer la conductivité électrique $\sigma$ ou la mobilité $\mu$ dans un matériau semi-conducteur. Une réalisation a été décrite par X. LE CLEAC'H, P-N FAVENNEC dans la demande de brevet français publiée sous le N° 2 623 291. Là encore on est limité en fréquence puisque les cavités ont l'inconvénient d'être monofréquences car le principe est basé sur une technique de résonance.

En ce qui concerne les lignes coaxiales ouvertes, la limitation est apportée quant à la nature des matériaux à contrôler. En effet, les lignes coaxiales ouvertes ont été étudiées pour la mesure de la permittivité complexe de substances biologiques dans le cadre de la recherche médicale, et également de liquides ou de matières molles. On peut se reporter à l'article de STUCHLY "Equivalent circuit of an open-ended coaxial line in a lossy dielectric", IEEE Trans. Instrum. Meas. vol. IM-31, N° 2, Juin 1982.

La limitation est la même pour les méthodes utilisant la technique de la sonde coaxiale en général. Ces sondes peuvent être utilisées dans une large bande de fréquences (100 MHz - 4 GHz) mais nécessitent un bon contact au niveau de l'interface sonde-matériau. Cette condition n'est pas réalisée que pour les exemples précités, liquides ou matières molles, mais reste un point délicat non résolu pour les matériaux "durs".

L'invention a pour objet un dispositif de caractérisation diélectrique permettant de remédier à tous ces inconvénients.

Un article intitulé "Low-Temperature Radio Frequency Matching Device" de A.V. Golik, A.Z. Korolyuk et V.I. Khizhnyi ("Instruments and Experimental Techniques", vol. 30, n° 2, mars 1987, New-York, USA, pages 491-492) décrit un dispositif faible température utilisé pour étudier les effets en amplitude et en polarisation de transformation mutuelle d'ondes électromagnétiques et acoustiques dans des métaux. Ce dispositif peut adapter des lignes d'alimentation avec des charges complexes faible-impédance.

Par contre, le dispositif selon l'invention permet de connaître avec une bonne résolution les caractéristiques diélectriques d'échantillons de matériau composite rigide de forme plane et non plane de géométrie connue, dans le domaine des fréquences radio et hyper-fréquences.

Ce dispositif s'applique en outre au contrôle non destructif de l'homogénéité diélectrique de tels échantillons.

L'invention a plus particulièrement pour objet un dispositif de caractérisation diélectrique d'échantillons de matériau de surface plane et/ou non plane à large bande de fréquence comprenant une sonde reliée à une ligne coaxiale par un connecteur comportant un conducteur extérieur et un conducteur central, principalement caractérisé en ce que la sonde comporte :

- une pièce tubulaire conductrice dont l'extrémité supérieure est destinée à être reliée au conducteur extérieur du connecteur, dont l'extrémité inférieure formant l'embase de la sonde s'étend vers l'extérieur de manière à présenter une surface annulaire plane,
- une tige conductrice, coaxiale à la pièce tubulaire, centrée dans celle-ci, et dont l'extrémité supérieure est destinée à être en contact électrique avec le conducteur central du connecteur, et dont l'extrémité inférieure est destinée à être en contact avec le matériau à caractériser,
- une pièce annulaire en matériau diélectrique logée dans la pièce tubulaire, solidairement à la tige, sa périphérie extérieure étant en contact de frottement avec la surface intérieure de la pièce tubulaire, en ce que l'ensemble pièce annulaire et tige coulisse dans la pièce tubulaire en opposant une résistance lorsque l'extrémité inférieure de la tige est en contact avec l'échantillon, ce qui assure un bon contact avec ce dernier, et en ce que cette extrémité inférieure ayant au moins un axe qui coïncide avec une génératrice de cette surface, le contact a toujours lieu, que la surface soit plane ou non plane.

Afin de résoudre le problème du contact entre la sonde et un échantillon de matériau rigide à surface plane, l'extrémité inférieure de la tige conductrice a une forme circulaire de manière à ce que les lignes du champ électrique $\vec{E}$ créé lorsque la sonde est parcourue par des courants transmis par la ligne coaxiale, soient réparties uniformément autour de cette tige.

Afin de résoudre le problème du contact entre la sonde et un échantillon de matériau rigide à surface non plane ou convexe, l'extrémité inférieure de la tige conductrice a une forme allongée de manière à favoriser les lignes de champ sur les bords extérieurs sensiblement parallèles à l'axe longitudinal de cette extrémité.

Selon un aspect de l'invention, l'ensemble pièce annulaire et tige conductrice est rendu coulissant et oppose une résistance par des moyens mécaniques réalisés par une pièce conductrice amovible et mobile dont une extrémité basse est plaquée contre l'extrémité supérieure de la tige conductrice, l'extrémité haute de cette pièce ayant la forme d'un entonnoir, forme adaptée pour pénétrer partiellement à l'intérieur de la partie inférieure du conducteur placé dans le connecteur et assurer en même temps un contact électrique.

Selon un autre aspect de l'invention, l'ensemble pièce annulaire et tige conductrice est rendu coulissant et oppose une résistance par des moyens mécaniques et pneumatiques, une arrivée d'air comprimé étant prévue soit dans le connecteur, soit dans la sonde.

Selon un mode de réalisation, au moins une arrivée d'air est ménagée dans la paroi du conducteur extérieur en amont ou en aval de la connexion du dispositif avec la ligne coaxiale, et les extrémités du conducteur central du connecteur et de la tige conductrice destinées à être en contact ont une forme adaptée de sorte que l'une puisse coulisser dans l'autre.

L'invention concerne en outre d'utilisation de ce dispositif pour le contrôle non destructif de l'homogénéité diélectrique d'échantillons de matériau, l'impédance étant mesurée au niveau de l'interface sonde-matériau. Cette utilisation consiste par ailleurs dans le cas d'un échantillon de surface plane à placer l'échantillon sur une table couplée à des moyens de déplacement permettant de la déplacer suivant deux axes orthogonaux (X, Y) dans le plan de cette table, le dispositif étant également couplé à ces moyens de déplacement qui lui permettent d'être déplacé au-dessus de la table suivant un axe orthogonal (Z) aux deux autres, et consiste à placer une ventouse autour des extrémités de l'embase de la sonde du dispositif et à relier cette ventouse à une pompe à vide de manière à améliorer le plaquage du dispositif sur l'échantillon à chaque position de mesure. Les échantillons de surface non plane sont placés sur un mandrin tournant.

L'invention sera mieux comprise à l'aide de la description faite à titre d'exemple non limitatif en regard des figures annexées, dans lesquelles :

- les figures 1a, 1b, 1c, représentent, à titre de rappel, respectivement les coupes transversales, longitudinales et le schéma électrique équivalent d'une ligne coaxiale,
- la figure 2 représente l'évolution des capacités Co et Cf en fonction de la permittivité ε' pour une fréquence donnée,
- la figure 3 représente un schéma de principe d'un dispositif permettant la caractérisation diélectrique d'échantillons rigides,
- la figure 4a représente le schéma d'une coupe de la sonde conforme à l'invention selon l'axe AA de la figure 3 et selon un premier mode de réalisation,
- la figure 4b représente le schéma d'une coupe transversale de la sonde selon la figure 4a, avec le détail de la répartition des lignes de champ électrique sur la figure 4c,
- la figure 5a représente le schéma d'une coupe de la sonde conforme à l'invention selon l'axe AA de la figure 3, selon un deuxième mode de réalisation,
- la figure 5b représente le schéma d'une coupe transversale de la sonde selon la figure 5a, avec le détail de la répartition des lignes de champ électrique sur la figure 5d,
- la figure 5c représente le schéma d'une coupe de la sonde placée sur un échantillon de surface non plane,
- la figure 6, représente un schéma d'une coupe plus détaillée du connecteur et d'une sonde selon une variante de réalisation,
- la figure 7 représente un schéma d'une coupe plus détaillée du connecteur et d'une sonde selon une deuxième variante de réalisation,
- la figure 8 représente le schéma du dispositif de contrôle de l'homogénéité diélectrique d'un échantillon conformément à l'invention,
- la figure 9 représente une variante de réalisation adaptée au contrôle d'échantillons de surface non plane.

Le principe de l'invention utilise la théorie de base de la ligne coaxiale en circuit ouvert et permet, comme cela est détaillé dans ce qui suit, de résoudre le problème du contact (interface sonde/ matériau à mesurer) sur un diélectrique rigide de forme plane et/ou non plane.

La ligne coaxiale en circuit ouvert est utilisée comme sonde ou détecteur pour la mesure des caractéristiques diélectriques de matériaux, dans le domaine des fréquences radio et hyperfréquences.

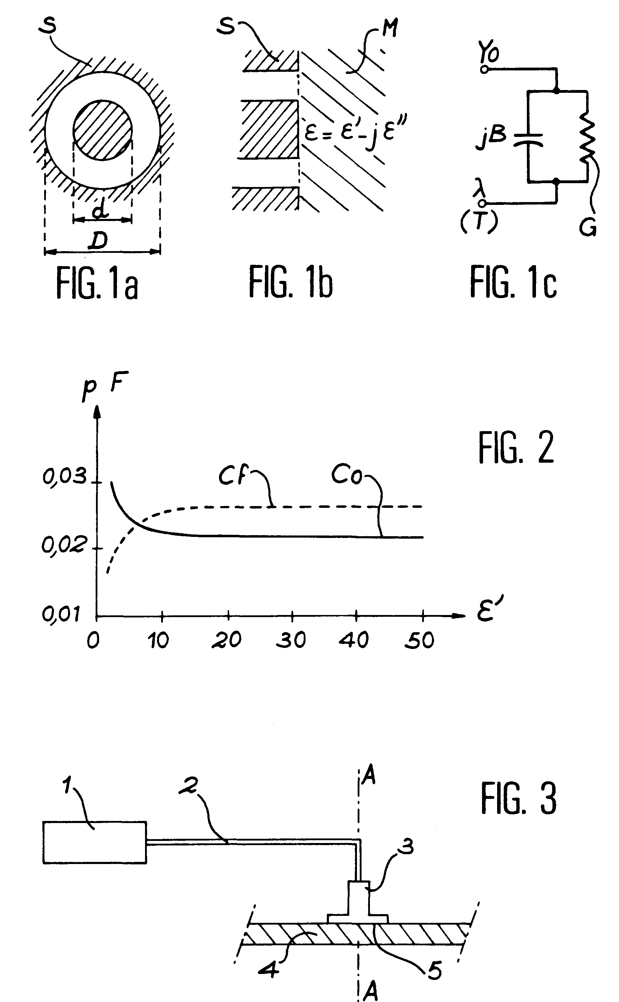

Le principe de la méthode est basé sur la mesure du coefficient de réflexion à l'interface sonde S - matériau M. On considère que la propagation dans la ligne se fait selon le mode TEM et que les éléments sont localisés. La sonde S est alors représentée par le schéma équivalent des figures 1a, 1b, 1c.

Le coefficient de réflexion est directement lié à l'admittance $Y = G + jB$, l'impédance caractéristique de la ligne étant $Zo = 1/Yo$. La permittivité relative $\varepsilon'$ est liée à l'admittance par la relation suivante $B = Co\omega\varepsilon' + Cf\omega$, où $\omega = 2\pi F$ ; F étant la fréquence, Co la capacité liée au champ électrique concentré dans le matériau en contact avec la sonde et, Cf la capacité liée au champ électrique concentré dans la ligne. La conductance G est liée aux pertes diélectriques dans le matériau.

La caractérisation diélectrique consiste à déterminer la permittivité $\varepsilon'$ et les pertes dans le matériau $\varepsilon''$, en utilisant les relations qui suivent :

$$\varepsilon' = \frac{B}{\omega.Co} - \frac{Cf}{Co} = K'$$

$$\varepsilon'' = \frac{G}{\omega.Co} = K''$$

Pour les fréquences supérieures à 1 GHz et pour des matériaux à forte permittivité ($\varepsilon' > 20$), il faut prendre en compte un terme lié à la conductance Go de la sonde ouverte à l'espace libre, qui s'ajoute aux expressions précédentes :

$$\varepsilon' = K' - \frac{Go}{\omega.Co}\beta$$

avec $\alpha + jB = (K'-jK'')^{5/2}$

$$\varepsilon'' = K'' - \frac{Go}{\omega.Co}\alpha$$

Les grandeurs Co et Cf peuvent être déterminées par étalonnage au moyen de plaques de permittivité connue, en fonction de la fréquence.

La figure 2 montre l'évolution de ces capacités en fonction de $\varepsilon'$ à la fréquence 1 GHz (exemple d'étalonnage de la sonde déterminée expérimentalement dans le cas du standard KMR).)

La figure 3 est le schéma de principe d'un dispositif permettant la caractérisation diélectrique d'échantillons rigides conformément à l'invention.

Ce dispositif comporte une sonde de mesure 3, connectée par l'intermédiaire d'une ligne coaxiale 2 à un analyseur de réseau vectoriel 1 (par exemple un analyseur HP 8510B), qui mesure l'impédance au niveau de l'interface 5 sonde 3 - matériau 4, dans la bande de fréquences désirées selon une réalisation particulière (100 MHz-4GHz). Les mesures sont faites dans toute la bande de fréquence par la même sonde.

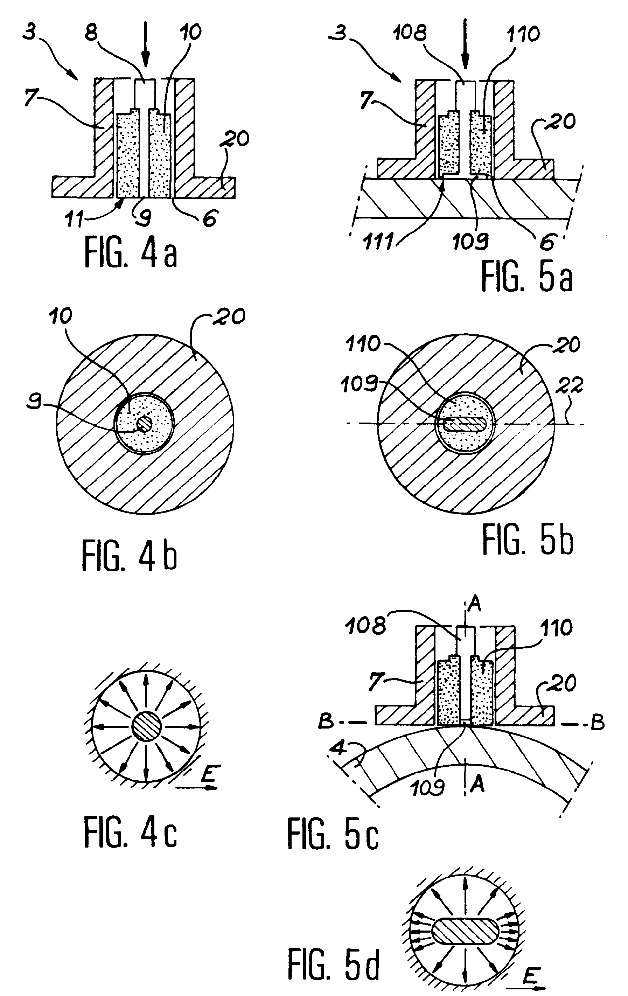

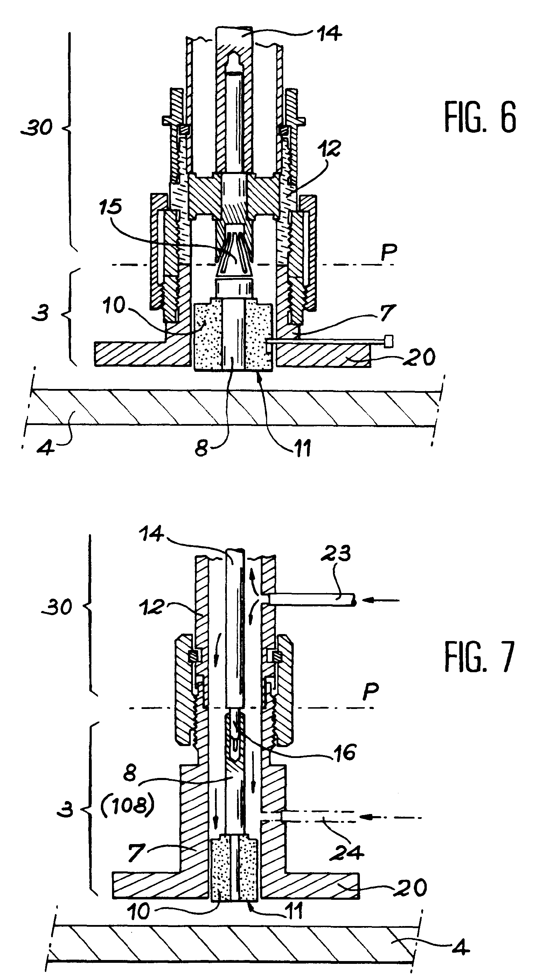

Comme on peut le voir sur les figures 4a et 5a la sonde 3 est composée de :
- une pièce tubulaire extérieure, conductrice 7 dont l'extrémité supérieure, telle que cela est représenté sur la figure, est destinée à être reliée au conducteur extérieur de la ligne coaxiale par l'intermédiaire d'un connecteur 30 visible sur les figures 6 et 7. L'extrémité basse 20 sur la figure formant l'embase de la sonde s'étend vers l'extérieur et présente une surface annulaire plane suffisamment élevée pour assurer un bon rayonnement de la sonde (on choisit par exemple trois fois le diamètre interne du conducteur extérieur),
- une partie centrale 11 (ensemble 8, 10), 111 (ensemble 108, 109, 110) composée d'une tige conductrice 8 ou 108 coaxiale à la pièce tubulaire 7 entourée d'une pièce annulaire en matériau diélectrique 10 ou 110 assurant un contact glissant 6 avec le conducteur extérieur 7.

L'extrémité haute, sur la figure, de la tige 8 ou 108 est destinée à être reliée par l'intermédiaire d'un connecteur à l'âme de la ligne coaxiale. L'extrémité basse est destinée à être en contact avec le matériau à caractériser.

La pièce diélectrique 10 ou 110 est solidaire de la tige 8 ou 108.

Comme cela sera précisé à propos des figures 6 et 7, la partie centrale 11 est coulissante et entraîne dans son mouvement, indiqué par une flèche, hors de la partie tubulaire la pièce diélectrique 10 (ou 110) et la tige 8 (ou 108).

La figure 4b correspond à une coupe transversale de la sonde représentée sur la figure 4a et permet de montrer un mode de réalisation de la tige 8 dans le cas où la sonde 3 est destinée à effectuer des mesures sur des échantillons à surface plane.

La forme de la tige est circulaire de manière à ce que les lignes du champ électrique $\vec{E}$ créé lorsque la sonde est parcourue par des courants transmis par la ligne coaxiale, soient réparties uniformément autour de cette tige (comme on peut le voir sur le détail de la figure 4c).

Les figures 5a, 5b, 5c, correspondent à la réalisation d'une sonde destinée à effectuer des mesures sur des échantillons de surface non plane (ou convexe dans l'exemple décrit).

L'extrémité 109 de la tige 108 est de forme allongée de manière à favoriser les lignes de champ sur les bords extérieurs qui sont sensiblement parallèles à l'axe longitudinal 22 de cette extrémité.

La coupe de la sonde de la figure 5a est prise dans un plan passant par l'axe longitudinal de l'extrémité 109 qui se trouve suivant une génératrice du matériau 4.

La coupe représentée sur la figure 5c permet de montrer une forme convexe du matériau 4.

Dans le cas de formes non planes (figure 5c), le volume d'air entre le matériau et la sonde est source d'erreur sur la détermination des caractéristiques diélectriques. Pour minimiser (voire supprimer) cette erreur, on fait intervenir un facteur de correction dans le calcul permettant de remonter aux valeurs de la permittivité complexe du matériau.

Ce facteur de correction est déduit de manière classique à partir d'un étalonnage au moyen de matériaux de caractéristiqes et formes connues, et permet de relier la valeur équivalente mesurée, en présence du volume d'air, à la valeur réelle du matériau.

Les figures 6 et 7 représentent le schéma plus détaillé d'une sonde 3 reliée à un connecteur 30 vus selon une coupe longitudinale. Le plan P est le plan interface connecteur sonde.

La figure 6 correspond à une première variante de réalisation permettant d'obtenir une partie centrale 11 ou 111 coulissante qui oppose une résistance lorsqu'elle est en contact avec le matériau. La partie centrale 11 (ou 111) est rendue coulissante selon cette première variante par des moyens mécaniques (poussée mécanique). Ces moyens mécaniques sont réalisés par une pièce conductrice 15 amovible et mobile dont une extrémité basse sur la figure est plaquée contre l'extrémité haute de la tige conductrice. L'extrémité haute de cette pièce 15 a la forme d'un entonnoir, forme adaptée pour pénétrer partiellement à l'intérieur de la partie extrême de l'âme 14 placée dans le connecteur et assurer en même temps un contact électrique.

Cette pièce 15 assure donc la continuité électrique entre le conducteur central 14 du connecteur 12 et le conducteur central 8 (ou 108). Lorsque la sonde 3 est raccordée au connecteur 30, la pièce 15 repousse le corps interne 11 coulissant dans le conducteur extérieur 7 de la sonde. Au moment où la sonde sera plaquée contre le matériau 4, le corps interne 11 repoussera la pièce 15 à l'intérieur de son conducteur central 14. Ainsi, la tige 8 de la sonde sera toujours en contact, d'une part avec le conducteur central 14 du connecteur, d'autre part avec le matériau à tester.

La figure 7 représente une deuxième variante de réalisation. Cette deuxième variante permet d'obtenir une partie centrale 11 (ou 111) coulissante par des moyens mécaniques et pneumatiques, la poussée étant pneumatique. Une arrivée d'air comprimé est prévue soit dans le connecteur 30, soit dans la sonde 3. Pour simplifier, on a représenté les deux solutions possibles sur la même figure 7.

L'extrémité du conducteur central 16 est fixe. Pour assurer le mouvement de la pièce 11 de la sonde 3, de l'air comprimé est envoyé en surpression dans le connecteur 30 par l'arrivée 23, ou dans la sonde 3 par l'arrivée 24, et a pour effet de repousser la pièce 11 (effet ressort).

Ce n'est qu'au moment où la sonde est en contact avec le matériau que la pièce 11 de la sonde vient en contact avec le conducteur central 14 par son extrémité 16 et ainsi la mesure peut être faite.

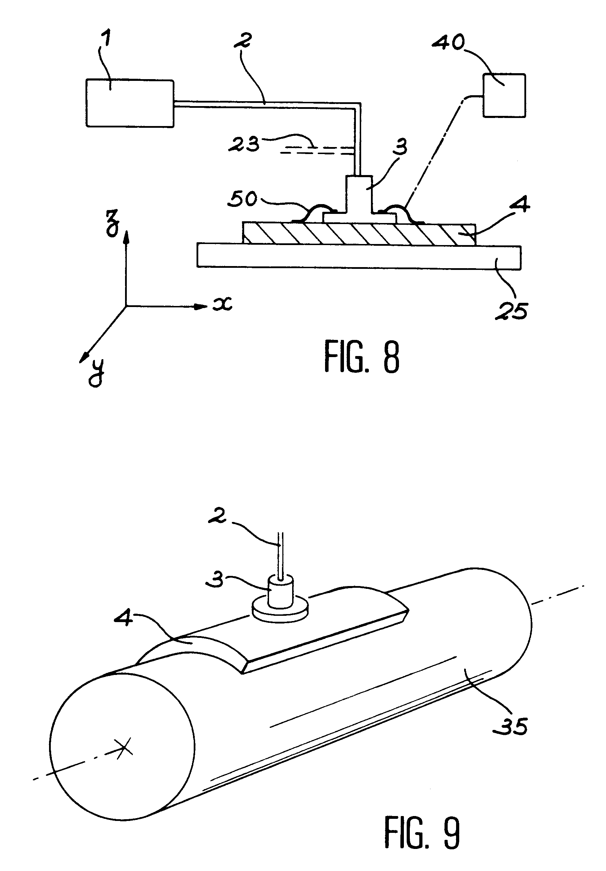

La figure 8 montre un exemple de dispositif de contrôle non destructif des caractéristiques diélectriques locales d'un échantillon et de l'homogénéité diélectrique du même échantillon.

L'échantillon 4 est fixé à une table 25 entraînée par des moyens de déplacement selon deux axes X ou Y à mouvements croisés classiques en soi et non représentés. Ces moyens permettent en outre d'avoir un mouvement suivant la direction Z pour amener la sonde en contact mécanique avec l'échantillon. Une pompe à dépression 40 classique, reliée à une ventouse 50 placée autour du dispositif permet d'obtenir un bon contact sonde-matériau. La table 25 permet ensuite de déplacer l'échantillon suivant les directions X et Y lorsque la sonde est écartée de l'échantillon pour permettre une mesure à un nouveau point. Les déplacements requis et les mesures sont réalisés de façon automatique par l'intermédiaire d'un calculateur et d'un programme numérique qui restitue également les caractéristiques diélectriques du matériau. Tout dispositif classique à commande numérique permet d'obtenir la commande des déplacements de la table et les calculs désirés sans difficulté pour l'homme de métier.

Comme représenté sur la figure 9, pour le contrôle de formes cylindriques ou coniques, le principe de mesure est le même, mais le mécanisme de déplacement diffère en ce que l'échantillon est placé sur un mandrin tournant 35, muni d'un déplacement suivant l'axe Z. Le dispositif permet un balayage de l'ensemble des génératrices de l'échantillon cyclindrique ou conique.

**Revendications**

1. Dispositif de caractérisation diélectrique d'échantillons de matériau de surface plane et/ou non plane à large bande de fréquence comprenant une sonde (3) reliée à une ligne coaxiale (2) par un connecteur (30) comportant un conducteur extérieur (12) et un conducteur central (14), caractérisé en ce que la sonde (3) comporte :

   - une pièce tubulaire (7) conductrice dont l'extrémité supérieure est destinée à être reliée au conducteur extérieur (12) du connecteur, dont l'extrémité inférieure formant l'embase de la sonde s'étend vers l'extérieur de manière à présenter une surface annulaire plane,
   - une tige (8 ou 108) conductrice, coaxiale à la pièce tubulaire (7), centrée dans celle-ci et dont l'extrémité supérieure est destinée à être en contact électrique avec le conducteur central (14) du connecteur (30) et dont l'extrémité inférieure est destinée à être en contact avec le matériau à caractériser,
- une pièce annulaire (10, 110) en matériau diélectrique logée dans la pièce tubulaire (7) solidairement à la tige (8 ou 108), sa périphérie extérieure étant en contact de frottement avec la surface intérieure de la pièce tubulaire,

en ce que l'ensemble pièce annulaire (10, 110) et tige (8, 108) coulisse dans la pièce tubulaire (7) en opposant une résistance lorsque l'extrémité inférieure de la tige est en contact avec l'échantillon (4), ce qui assure un bon contact avec ce dernier ; et en ce que cette extrémité inférieure ayant au moins un axe qui coïncide avec une génératrice de cette surface, le contact a toujours lieu, que la surface soit plane ou non plane.

2. Dispositif de caractérisation diélectrique d'échantillons de matériau de surface plane selon la revendication 1, caractérisé en ce que l'extrémité inférieure (9) de la tige conductrice (8) a une forme circulaire de manière à ce que les lignes du champ électrique $\vec{E}$ créé lorsque la sonde est parcourue par des courants transmis par la ligne coaxiale, soient réparties uniformément autour de cette tige.

3. Dispositif de caractérisation diélectrique d'échantillons de matériau de surface non plane selon la revendication 1, caractérisé en ce que l'extrémité inférieure (109) de la tige conductrice (108) a une forme allongée de manière à favoriser les lignes de champ sur les bords extérieurs sensiblement parallèles à l'axe longitudinal de cette extrémité inférieure.

4. Dispositif selon l'une quelconque des revendications 1 à 3, caractérisé en ce que l'ensemble tige conductrice (8 ou 108) et pièce annulaire (10 ou 110) est rendu coulissant et oppose une résistance par des moyens mécaniques réalisés par une pièce conductrice (15) amovible et mobile dont une extrémité basse est plaquée contre l'extrémité supérieure de la tige conductrice, l'extrémité haute de cette pièce ayant la forme d'un entonnoir, forme adaptée pour pénétrer partiellement à intérieur de la partie inférieure du conducteur central (14) placé dans le connecteur (30) et assurer en même temps un contact électrique.

5. Dispositif selon l'une quelconque des revendications 1 à 3, caractérisé en ce que l'ensemble tige conductrice (8 ou 108) et pièce annulaire (10 ou 110) est rendu coulissant et oppose une résistance par des moyens pneumatiques et mécaniques, une arrivée d'air comprimé étant prévue soit dans le connecteur (30), soit dans la sonde (3).

6. Dispositif selon la revendication 5, caractérisé en ce qu'au moins une arrivée d'air (23, 24) est ménagée dans la paroi du conducteur extérieur en amont ou en aval de la connexion du dispositif avec la ligne coaxiale et en ce que les extrémités du conducteur central (14) du connecteur (30) et de la tige conductrice (8, 108) destinées à être en contact ont une forme adaptée, de sorte que l'une puisse coulisser dans l'autre.

7. Utilisation du dispositif selon une des revendications 1 à 6 pour le contrôle non destructif de l'homogénéité diélectrique d'échantillons de matériau, caractérisé en ce que l'impédance est mesurée au niveau de l'interface (5) sonde (3)-matériau (4).

8. Utilisation selon la revendication 7, caractérisée en ce qu'elle consiste, dans le cas d'un échantillon de surface plane, à placer l'échantillon (4) sur une table (25) couplée à des moyens de déplacement permettant de la déplacer suivant deux axes orthogonaux (X, Y) dans le plan de cette table (25), le dispositif étant également couplé à ces moyens de déplacement qui lui permettent d'être déplacé au-dessus de la table suivant un axe orthogonal (Z) aux deux autres, et en ce qu'il consiste à placer une ventouse (50) autour des extrémités recourbées du dispositif et à relier cette ventouse à une pompe à vide (40) de manière à améliorer le plaquage du dispositif sur l'échantillon à chaque position de mesure.

9. Utilisation selon la revendication 7, caractérisée en ce qu'elle consiste, dans le cas d'un échantillon de surface non plane, à placer l'échantillon sur un mandrin tournant (35) couplé à des moyens de déplacement suivant un axe (Z) orthogonal au plan du plateau.

**Patentansprüche**

1. Vorrichtung zur Charakterisierung der dielektrischen Eigenschaften von Proben, deren Oberfläche flach und/oder nicht flach ist, mit breitem Frequenzbereich, umfassend eine Sonde (3), verbunden mit einem Koaxilalkabel (2) durch einen Steckverbinder (30), enthaltend einen Außenleiter (12) und eine Kernader (14), dadurch **gekennzeichnet,**
daß die Sonde umfaßt:
- ein leitendes, röhrenförmiges Teil (7), dessen oberes Ende dazu bestimmt ist, mit dem Außenleiter (12) des Steckverbinders verbunden zu werden, dessen unteres Ende, das den Sockel der Sonde bildet, sich nach außen erstreckt, um eine ringförmige, plane Oberfläche zu bilden,

- eine leitende Stange (8 oder 108), koaxial zu dem röhrenförmigen Teil (7), in diesem zentriert, deren oberes Ende dazu bestimmt ist, elektrischen Kontakt herzustellen mit der Kernader (14) des Steckverbinders (30), und deren unteres Ende dazu bestimmt ist, Kontakt herzustellen mit dem zu charakterisierenden Material,

- ein ringförmiges Teil (10, 110) aus dielektrischem Material, untergebracht in dem röhrenförmigen Teil (7), formschlüssig mit der Stange (8, 108), wobei sein Außenumfang Reibungskontakt hat mit der Innerfläche des röhrenförmigen Teils,

daß der Aufbau aus ringförmigem Teil (10, 110) und Stange (8, 108) in dem röhrenförmigen Teil (7) gleitet, gegen einen Widerstand, wenn das untere Ende der Stange in Kontakt ist mit der Probe (4), was einen guten Kontakt mit dieser gewährleistet; und dadurch, daß dieses untere Ende wenigstens eine Achse aufweist, die zusammenfällt mit einer Mantellinie dieser Oberfläche, wobei der Kontakt immer stattfindet, unabhängig davon, ob die Oberfläche plan oder nichtplan ist.

2. Vorrichtung zur dielektrischen charakterisierung von Materialproben mit planer Oberfläche nach Anspruch 1, dadurch gekennzeichnet, daß das untere Ende (9) der leitenden Stange (8) eine kreisrunde Form aufweist, so daß die Linien des elektrischen Feldes $\vec{E}$ ,erzeugt wenn die Sonde durchflossen wird von Strömen, die übertragen werden durch das Koaxialkabel, gleichmäßig um diese Stange herum verteilt sind.

3. Vorrichtung zur dielektrischen Charakterisierung von Materialproben mit nichtplaner Oberfläche nach Anspruch 1, dadurch gekennzeichnet, daß das untere Ende (109) der leitenden Stange (108) eine gestreckte Form aufweist, um die Feldlinien an den Außenrändern zu begünstigen, im wesentlichen parallel zu der Längsachse dieses unteren Endes.

4. Vorrichtung nach einem der Ansprüche 1 bis 3, dadurch gekennzeichnet, daß der Aufbau aus leitender Stange (8 oder 108) und ringförmigem Teil (10 oder 110) gleitend gemacht ist, und einem Widerstand durch mechanische Einrichtungen begegnet, verwirklicht durch ein leitendes Teil (15), lose und beweglich, wovon ein unteres Ende anliegt an dem oberen Ende der leitenden Stange und das obere Ende dieses Teils die Form eines Trichters aufweist, wobei diese Form so ausgebildet ist, daß sie partiell eindringt in das Innere des unteren Teils der Kernader (14), angeordnet in dem Steckverbinder (30), und zugleich einen elektrischen Kontakt gewährleistet.

5. Vorrichtung nach einem der Ansprüche 1 bis 3, dadurch gekennzeichnet, daß der Aufbau aus leitender Stange (8 oder 108) und ringförmigem Teil (10 oder 110) gleitend gemacht ist und einem Widerstand begegnet mittels pneumatischer und mechanischer Einrichtungen, wobei eine Luftzuführung vorgesehen ist, entweder im dem Steckverbinder (30) oder in der Sonde (3).

6. Vorrichtung nach Anspruch 5, dadurch gekennzeichnet, daß wenigstens eine Luftzuführung (23, 24) angebracht ist in der Wand des Außenleiters vor oder nach der Verbindung der Vorrichtung mit dem Koaxialkabel, und dadurch, daß die Enden der Kernader (14) des Steckverbinders (30) und der leitenden Stange (8, 108), vorgesehen für den Kontakt, eine angepaßte Form aufweisen, so daß man das eine in das andere schieben kann.

7. Anwendung der Vorrichtung nach einem der Ansprüche 1 bis 6 zur zerstörungsfreien Untersuchung der dielektrischen Homogenität von Materialproben, dadurch gekennzeichnet, daß die Impedanz gemessen wird auf der Ebene der Grenzfläche (5) Sonde (3) - Material (4).

8. Anwendung nach Anspruch 7, dadurch gekennzeichnet, daß sie im Falle einer Probe mit planer Oberfläche darin besteht, die Probe (4) auf einem Tisch (25) anzuordnen, der gekoppelt ist mit Verschiebungseinrichtungen, die ermöglichen, sie in zwei rechtwinkligen Achsen (X, Y) in der Ebene dieses Tisches (25) zu verschieben, wobei die Vorrichtung ebenfalls gekoppelt ist mit Einrichtungen, die ermöglichen, sie über dem Tisch in einer Achse (Z) zu verschieben, die rechtwicklig ist zu den beiden anderen, und dadurch, daß sie darin besteht, einen Balg (50) um die gekrümmten Enden der Vorrichtung herum anzubringen, und diesen Balg mit einer Vakuumpumpe (40) zu verbinden, um das Festmachen der Vorrichtung an der Probe in jeder Meßposition zu verbessern.

9. Anwendung nach Anspruch 7, dadurch gekennzeichnet, daß sie darin besteht, im Falle einer Probe mit nichtplaner Oberfläche, die Probe auf einem drehbaren Dorn (35) anzubringen, gekoppelt mit Verschiebungseinrichtungen in einer Achse (Z), rechtwinklig zur Ebene der Platte.

## Claims

1. Device for the dielectric characterization of samples of material having an even and/or uneven surface with a wide frequency band incorporating a probe (3) connected to a coaxial line (2) by a connector (30) having an external conductor (12) and a central conductor (14), characterized in that the probe (3) incorporates a conductive tubular part (7), whose upper end is connected to the external conductor (12) of the connector and whose lower end forming the base of the probe extends towards the outside so as to have a planar annular surface, a conductive rod (8) or (108) coaxial to the tubular part (7) and centered in the latter and whose upper end comes into electrical contact with the central conductor (14) of the connector (30) and whose lower end is to be in contact with the material to be characterized and an annular, dielectric material part (10, 110) located in the tubular part (7) integral with the rod (8) or (108), its outer periphery being in friction contact with the internal surface of the tubular part and in that the assembly formed by the annular part (10, 110) and the rod (8, 108) slides in the tubular part (7) opposing a resistance when the lower end of the rod is in contact with the sample (4), which ensures a good contact with the latter and in that said lower end has at least one axis which coincides with a generatrix of said surface, contact always taking place no matter whether the surface is even or uneven.

2. Device for the dielectric characterization of samples of material having an even surface according to claim 1, characterized in that the lower end (9) of the conductive rod (8) has a circular shape so that the electric field lines ( $\vec{E}$ ) created when the probe is traversed by currents transmitted by the coaxial line are uniformly distributed about said rod.

3. Device for the dielectric characterization of material samples having an uneven surface according to claim 1, characterized in that the lower end (109) of the conductive rod (108) has an elongated shape so as to favor the field lines on the outer edges substantially parallel to the longitudinal axis of said lower end.

4. Device according to any one of the claims 1 to 3, characterized in that the assembly of the conductive rod (8) or (108) and the annular part (10) or (110) is made to slide and opposes a resistance by mechanical means produced by a detachable, mobile conductive part (15), whereof a lower end is engaged against the upper end of the conductive rod, the upper end of said part being funnel-shaped, said shape being appropriate for partly penetrating the interior of the lower portion of the central conductor (14) placed in the connector (30) and at the same time ensuring an electrical contact.

5. Device according to any one of the claims 1 to 3, characterized in that the assembly of the conductive rod (8) or (108) and the annular part (10) or (110) is made to slide and opposes a resistance by pneumatic and mechanical means, a compressed air intake being provided in the connector (30) or in the probe (3).

6. Device according to claim 5, characterized in that at least one air intake (23, 24) is provided in the wall of the outer conductor upstream or downstream of the connection of the device to the coaxial line and in that the ends of the central conductor (14) of the connector (30) and the conductive rod (8, 108) intended to come into contact have a matched shape, so that one can slide in the other.

7. Use of the device according to any one of the claims 1 to 6 for the non-destructive control of the dielectric homogeneity of material samples, characterized in that the impedance is measured at the interface (5) between the probe (3) and the material (4).

8. Use according to claim 7, characterized in that, in the case of a sample having an even surface, it consists of placing the sample (4) on a table (25) coupled to displacement means making it possible to displace it along two orthogonal axes (X,Y) in the plane of said table 25, said device also being coupled to displacement means enabling it to be displaced above the table along an axis (Z) orthogonal to the two other axes and in that it consists of placing a suction cup (50) around the curved ends of the device and connecting said suction cup to a vacuum pump (40), so as to improve the engagement of the device on the sample in each measuring position.

9. Use according to claim 7, characterized in that in the case of a sample with an uneven surface, it consists of placing the sample on a rotary mandrel (35) coupled to displacement means along an axis (Z) orthogonal to the plane of the plate.

FIG. 1a    FIG. 1b    FIG. 1c

$\varepsilon = \varepsilon' - j\varepsilon''$

FIG. 2

FIG. 3

FIG. 4 a

FIG. 5a

FIG. 4 b

FIG. 5b

FIG. 4 c

FIG. 5 c

FIG. 5d

FIG. 6

FIG. 7

FIG. 8

FIG. 9